# EUROPEAN PATENT SPECIFICATION

(11) **EP 3 747 042 B1**
(45) Date of publication and mention of the grant of the patent: **02.08.2023**
(21) Application number: 19704400.1
(22) Date of filing: 30.01.2019
(51) Int. Cl.: H01L 21/67, H01L 21/677

(54) **SYSTEM AND METHOD FOR MANUFACTURING A PLURALITY OF INTEGRATED CIRCUITS**
SYSTEM UND VERFAHREN ZUR HERSTELLUNG VON MEHREREN INTEGRIERTEN SCHALTUNGEN
SYSTÈME ET PROCÉDÉ DE FABRICATION D'UNE PLURALITÉ DE CIRCUITS INTÉGRÉS

(30) Priority: 30.01.2018 GB 201801473; 09.05.2018 GB 201807577
(43) Date of publication of application: 09.12.2020
(73) Proprietor: PragmatIC Printing Ltd, Sedgefield Durham TS21 3FG (GB)
(72) Inventor: PRICE, Richard David, Durham TS21 3FG (GB); DAVIES, Neil, Durham TS21 3FG (GB); WHITE, Scott, Durham TS21 3FG (GB); VAN DEN HEEVER, Thomas Stanley, Durham TS21 3FG (GB); WILLIAMSON, Kenneth David, Durham TS21 3FG (GB); GREEN, Nathaniel James, Durham TS21 3FG (GB)
(74) Representative: HGF
(86) International application number: PCT/GB2019/050250
(87) International publication number: WO 2019/150100

(56) References cited:
- WO-A1-2014/143846
- WO-A1-2014/143846
- US-A- 6 074 443
- US-A- 6 074 443
- US-A1- 2008 133 041
- US-B2- 7 988 399
- US-B2- 7 988 399

## Description

### FIELD OF THE INVENTION

The present invention relates to a system and methods for manufacturing a plurality of integrated circuits, and in particular, although not exclusively, to a system and method suitable for mass production of high volumes of integrated circuits.

### BACKGROUND

A wide variety of techniques are known for manufacturing integrated circuits for incorporation in larger, overall electronic circuits, typically connected via contact pads. Often, the techniques for manufacturing those integrated circuits (or ICs) result in the formation of an array of densely packed ICs on a common support (e.g. wafer) through a variety of processes including deposition, masking, etching, cleaning and so on. The formation of the integrated circuits on the common support occurs through the repetitive processes of deposition, masking, etching, cleaning and so on until the final circuit has been created on the common support. Those ICs then need to be separated from each other (e.g. by dividing the common support), separated from the common support, and/or handled in some way from that common support (which typically provided support during the IC production process) to their final or target destination on the larger electronic circuit.

The manufacture of ICs on the initial common support poses a number of problems. In silicon wafer formation, large batches of silicon common supports (typically up to 150 supports) are moved together through the manufacturing process in linear fashion, according to a pre-programmed protocol which sets the operating and processing parameters for the system, from a deposition station to a masking station, to an etching station to a wet cleaning station and so on until the IC is formed on the silicon support. Within each batch, are "lots" of 25 silicon wafers (i.e. one full cassette) which are never separated (except for process experimentation) through the manufacturing process. In order to be efficient, such processes require large and consistent batch sizes of common supports travelling in linear fashion to each of the stations in turn according to the pre-programmed protocol which remains unchanged throughout the processing of the common supports introduced to the system. Batches of 150 common supports (e.g. silicon wafers) are not uncommon in such processes. Each processing station will undertake one of the formation processes for one of the layers in the IC at any one time according to the pre-programmed protocol established at the start of the manufacturing process. Typical processes for manufacturing silicon wafers can be time consuming, costly and require large factory spaces to accommodate the apparatus. The systems operating the process typically contain a large number of common supports (e.g. wafers), or inventory, at any one time, due to the length and linear nature of the process. In addition, once the pre-programmed protocol for a manufacturing batch has been established, the system will run according to that protocol until the integrated circuits are formed on the common supports of that batch. In order to change the protocol, a new batch will need to start the manufacturing process from the beginning. Therefore, processing single or small batches of common supports to manufacture integrated circuits thereon according to a pre-programmed protocol is inefficient and commercially undesirable. In addition, changing any of the operating or process parameters from the pre-programmed protocol during manufacture for anything other than the entire population of common supports in that run, is not efficient nor commercially desirable.

The following relevant prior art documents are cited:
US 2008/133041 A1 discloses a method and system for controlling substrate handling at substrate buffers by interrupting process jobs depending on job priority.
US 2014/143846 A1 discloses a multi-position batch load lock apparatus, systems and methods of using.

The following documents are also mentioned as a complementary prior art illustration:
US 6074443 A
US 7988399 B2

### BRIEF SUMMARY OF THE DISCLOSURE

Accordingly, it is an object of certain embodiments of the invention to provide a system and methods for manufacturing a plurality of integrated circuits which overcome, at least partly, one or more of the problems associated with the prior art.

Aspects and embodiments of the invention provide a system for manufacturing a plurality of integrated circuits and a method for mass production of high volumes of integrated circuits as claimed in the appended claims. According to a first aspect of the invention there is provided a system for manufacturing a plurality of integrated circuits, ICs, mounted on a common support, according to claim 1.

In certain embodiments the system comprises at least one buffering station configured (adapted, arranged) to receive at least one common support.

In certain embodiments the system comprises a plurality of buffering stations configured (adapted, arranged) to receive at least one common support.

In certain embodiments the, or each, buffering station is configured (adapted, arranged) to receive at least one common support, the buffering station being located before one or more of: the input station, one or more of the processing modules and the output station.

In this way, the, or each, buffering station is configured to provide capacity to hold one or more common supports before the common support is directed into a station or module in the IC making process. The buffering station(s) provide the system with waiting stations in which batches of common supports can be brought together under the direction of the control means from anywhere else in the system before entering a station or module according to the processing protocol.

In certain embodiments the control means is operable to direct the movement of each common support into a buffering station. More specifically, the control means is operable to direct a plurality of common supports into a buffering station. Yet more specifically, the control means is operable to direct a plurality of common supports into a buffering station wherein each one of the plurality of common supports may have come from any other station or module in the system.

In certain embodiments the system comprises control means operable to direct the operation of one or more of the input, output and buffering stations, the transfer means and each of the processing modules.

In certain embodiments the control means comprises a system controller (e.g. control unit, control module) and a plurality of sub-system controllers (e.g. control unit, control module) operable to direct the system and each of the component stations and modules respectively.

In certain embodiments a processing protocol comprises processing steps and operating and processing parameters which together form the instructions for processing a common support through the system in order to form a plurality of integrated circuits thereon. The controller and sub-controllers are preferably operable to direct the at least one common support through the system according to a processing protocol.

In certain embodiments the at least one processing protocol comprises a changeable pre-programmed protocol.

In certain embodiments the control means is operable to direct at least one common support from the input station to the output station and to each processing module therebetween according to the changeable pre-programmed protocol in which a predetermined set sequence of processing steps and processing and operating parameters are followed by the controller to form a plurality of integrated circuits on the common support. In this way, the common support follows a pre-determined sequence of processing steps and parameters through the system from the input station to the output station and through each processing module therebetween.

In certain embodiments the changeable pre-programmed protocol comprises sequential direction of the, or each, common support to at least a deposition module, a patterning module and an etching module.

In certain embodiments the changeable pre-programmed protocol includes a repeatable sequence of processing steps for the formation of layers of an integrated circuit on a common support. In this way, the repetition of the sequence of processing steps occurs until a complete integrated circuit is formed on the at least one common support.

In certain embodiments, the at least one processing protocol comprises a plurality of changeable pre-programmed protocols. More specifically, the at least one processing protocol comprises a selected one of a plurality of changeable pre-programmed protocols. In this way, instructions in the form of changeable pre-programmed protocols for forming a range of products can be stored within the system to reduce the need for manual intervention when production changes from one product to another.

In certain embodiments, the control means is operable to select one of the plurality of changeable pre-programmed protocols for the at least one processing protocol.

In certain embodiments the at least one processing protocol comprises at least one dynamic protocol. According to a dynamic protocol, the controller is operable to change one or more of the: processing steps, operating parameters and processing parameters of the changeable pre-programmed protocol. More specifically, the controller is operable to change one or more of the: processing steps, operating parameters and processing parameters of the changeable pre-programmed protocol for at least one common support within the system. In this way, the at least one dynamic protocol overrides the pre-programmed protocol for the at least one common support during the formation of a plurality of integrated circuits on the common support.

In certain embodiments the control means is operable to initiate the at least one dynamic protocol to change one or more of the operating and processing steps and parameters of the changeable pre-programmed protocol to a dynamic protocol in which at least a part of the changeable pre-programmed processing protocol is altered.

In certain embodiments the control means is operable according to the least one dynamic protocol to direct a common support from the input to the output stations and to each processing module therebetween according to a processing cycle in which one or more of: processing speed, module or station dwell time, system dwell time, a processing time, a system or module population, a diversion missing a processing module from the pre-programmed protocol, a priority for the common support relative to another common support in the system, in one or more parts of the system is changed from the changeable pre-programmed protocol.

In certain embodiments the controller is operable to direct each common support from the input station to the output station and through one or more of the processing modules according to its own dynamic protocol. In this way, an individual common support in the system is under the direction of the control means independently of any other common support in the system. In this way, any one common support can be prioritised, delayed, reprocessed, cycled or otherwise treated independently in the system. Such control allows for a highly flexible system capable of handling single, small or large batches of common supports according to a number of different processing protocols at the same time.

In certain embodiments the controller is operable to direct each common support from the input station to the output station and through one or more of the processing modules during the formation of an integrated circuit thereon according to a changeable pre-programmed protocol in combination with at least one dynamic protocol.

In certain embodiments the at least one dynamic protocol comprises a repeatable sequence of processing steps for the formation of layers of an integrated circuit on a common support. In this way, the repetition of the sequence of processing steps occurs until a complete integrated circuit is formed on the at least one common support.

In certain embodiments the controller is operable to direct the or each common support according to the at least one dynamic protocol from any one of: the input station, a buffering station, a deposition module, a patterning module, an etching module and an output station to any one of: a buffering station, a deposition module, a patterning module, an etching module and an output station.

In certain embodiments the control means is operable to direct the, or each common support according to a plurality of dynamic protocols.

In certain embodiments the control means is operable to direct the movement of at least one common support to form a temporary batch comprising one or more common supports and to direct the transfer of that temporary batch to one of: the input station, a process module, a buffering station and the output station.

In certain embodiments the control means is operable to form a plurality of temporary batches of common supports, each batch comprising one or more common supports, and to direct each temporary batch to one of: the input station, a process module, a buffering station and the output station.

In certain embodiments the control means is operable to separate the common supports of a temporary batch and is further operable to form another temporary batch wherein each temporary batch of common supports comprises at least one common support not present in at least one other temporary batch of common supports.

In certain embodiments the control means is operable to continuously form and separate the common supports of a temporary batch wherein each temporary batch of common supports comprises at least one common support not present in at least one other temporary batch.

In certain embodiments each temporary batch has the same or a different number of common supports.

In certain embodiments the control means is operable to direct the one or more of movement, processing and/or transfer of the, or each, temporary batch according to one or more of: a changeable pre-programmed protocol and a dynamic protocol. In this way, the, or each, temporary batch of common supports is processed according to a pre-programmed and/or one or more dynamic protocols during the formation of a plurality of integrated circuits thereon.

In certain embodiments the control means is operable to direct one or more of the movement, processing and/or transfer of the, or each, temporary batch to one or more of: one or more processing units, buffering stations and the output station according to one or more of: a changeable pre-programmed protocol and a dynamic protocol.

In certain embodiments the input station and the output station are one and the same.

In certain embodiments the input station and the output station are separate units.

In certain embodiments the input station comprises a platform.

In certain embodiments the platform is slidably mounted to the transfer means.

In certain embodiments the platform is rotatably mounted to the transfer means.

In certain embodiments the input station comprises a batch loading device configured (adapted, arranged) to receive one or more common supports.

In certain embodiments the system comprises a plurality of batch loading devices.

In certain embodiments the, or each batch loading device is movable between one or more of: the transfer means, one or more modules, a buffering station, an input station and the output station.

In certain embodiments the, or each batch loading device comprises a cassette configured (adapted, arranged) to receive one or more common supports.

In certain embodiments the transfer means is a continuous transfer device.

In certain embodiments the transfer means comprises one or more of: one or more support moving devices, one or more rails, a carrier belt, a conveyor system and at least one common support holder.

In certain embodiments the one or more support moving devices comprise at least one robotic arm operable to move at least one common support from one module to another module or buffering station.

In certain embodiments the one or more support moving devices comprise a plurality of robotic arms operable to move at least one common support within a module, from one module to another module, to or from a station and/or to and/or from a buffering station. More specifically, robotic arms are operable to transfer the at least one common support into, out of and within the system. In this way, efficient transport of the at least one common support is ensured in a power efficient way.

In certain embodiments, the plurality of robotics arms are operable to move a batch loading device. More specifically, the batch loading device is configured to receive one or more common supports.

In certain embodiments, the, or each, robotic arm is configured to directly move one or more common supports.

In certain embodiments the system comprises a central buffering station and a plurality of robotic arms each operable to move at least one common support to and from the central buffering station to one or more of: a module, an output station and a buffering station.

In certain embodiment the support moving device(s) are operable to move one or more batch loading devices between one or more of: the transfer means, one or more modules, a buffering station, an input station and the output station.

In certain embodiments the plurality of processing modules in combination are operable to perform the integrated circuit formation steps of at least deposition, patterning and etching the common support to form an integrated circuit (IC) on the common support.

In certain embodiments the control means is operable to initiate a processing step in one or more modules according to a pre-programmed and/or a dynamic processing protocol.

In certain embodiments the system comprises a deposition processing module, a patterning processing module and an etching processing module operable respectively to deposit layers, to pattern layers and to etch into deposited layers on a common support in an integrated circuit formation process.

In certain embodiments the system comprises a cleaning processing module operable to clean debris from a common support in an integrated circuit formation process.

In certain embodiments each processing module is operable to perform a processing step, being a step in the formation of an integrated circuit, on one or more common supports directed to the module by the control means from any one of: the input station, a buffering station, a further processing module and the output station.

In certain embodiments a processing module is operable to perform one of a deposition, patterning, etching or cleaning processing step on a plurality of common supports which are each at the same or different stages of the process of formation of an integrated circuit as the other common supports in the plurality of common supports, contemporaneously as directed by the control means.

In certain embodiments each processing module is operable to perform at least one processing step, being a step in the formation of an integrated circuit, on one or more common supports directed to the module by the control means from any one of: the input station, a buffering station, a further processing module and the output station.

In certain embodiments each processing module is operable to perform a plurality of processing steps, being steps in the formation of an integrated circuit, on one or more common supports directed to the module by the control means from any one of: the input station, a buffering station, a further processing module and the output station.

In certain embodiments each processing module is operable to perform one or more of a deposition step, a patterning step, an etching step, a baking step and a cleaning step, being steps in the formation of an integrated circuit, on one or more common supports.

In certain embodiments each processing module comprises one or more sub-modules.

In certain embodiments, each sub-module within a processing module is operable to perform one of the processing steps in the formation of an integrated circuit.

In certain embodiments, a sub-module is operable to form at least one layer of an integrated circuit on a common support.

In certain embodiments, each sub-module is configured to receive one or more common supports.

In certain embodiments, a processing module may comprise a plurality of sub-modules. More specifically, the processing module comprises a cluster of sub-modules.

In certain embodiments, the cluster of sub-modules are operable to perform one of the processing steps in the formation of an integrated circuit on at least one common support. Each sub-module is typically operable to form at least one layer of an integrated circuit on a common support. For example, in a deposition processing module, each sub-module of the cluster may be operable to deposit different materials onto the common support.

In certain embodiments, each sub-module is configured (arranged, adapted) to receive at least one common support.

In certain embodiments, each sub-module is configured (arranged, adapted) to receive a plurality of common supports. More specifically, the plurality of common supports may be loaded directly into the sub-module. Alternatively, the plurality of common supports may be loaded into a batch loading device (e.g. a cassette or carousel) which is loaded into the sub-module.

In certain embodiments, a processing module comprises a single sub-module. In these embodiments, the single sub-module is configured (arranged, adapted) to receive one or more common supports. By providing only a single sub-module processing module, the number of handling steps to and from the transfer means are reduced relative to processing modules comprising a plurality of sub-modules.

In certain embodiments, each sub-module is operable to perform at least a part of a step in the process of making a plurality of integrated circuits.

In certain embodiments, each processing module comprises a single sub-module operable to perform one of the steps in the formation of an IC on a common support.

In certain embodiments, each sub-module is operable to receive one or more common supports at any one time.

In certain embodiments, a single sub-module may deposit a single layer of a plurality of integrated circuits on a common support. Alternatively, or in addition, a single sub-module may deposit multiple layers of a plurality of integrated circuits on a common support.

In certain embodiments, the system comprises one or more masks (or reticles) for each of a plurality of integrated circuit designs. In this way, a set of masks or reticles for each of the plurality of products to be produced by the system is stored in the system (e.g. in a lithography processing module).

In certain embodiments, the control means is operable to select a mask(s) (or reticle(s)) for the intended integrated circuit design to be made.

In certain embodiments the control means comprises a programmable CPU (e.g. a PC, laptop computer or the like).

In certain embodiments the CPU is programmed with software to implement the methods of the invention, to establish at least one processing protocol for the control means including processing steps, operating parameters and processing parameters for the control means.

In certain embodiments the software is executable to implement a changeable pre-programmed protocol and/or at least one dynamic protocol.

In certain embodiments the software is executable to implement at least one of a plurality of changeable pre-programmed protocols.

In certain embodiments, the system comprises an operator interface. More specifically, the operator interface is operably connected to the CPU and is operable to allow operator inputs and to provide outputs to the operator. The outputs may be visual and/or audible outputs for example.

According to a second aspect, the present invention provides a method of manufacturing a plurality of integrated circuits, IC, mounted on a common support, according to claim 10.

In certain embodiments the method comprises selecting the one changeable pre-programmed protocol from the plurality of changeable pre-programmed protocols.

In certain embodiments the method comprises selecting one or more masks (or reticles) for an integrated circuit design.

In certain embodiments the method comprises providing a plurality of buffering stations configured (adapted, arranged) to receive at least one common support.

In certain embodiments the method comprises receiving at least one common support into a buffering station before one or more of: the input station, one or more of the processing modules and the output station.

In certain embodiments the method comprises directing the movement of at least one common support into a buffering station.

In certain embodiments the method comprises directing the movement of a common support to form a temporary batch of common supports comprising one or more common supports and directing the transfer of that temporary batch to one of: the input station, a process module, a buffering station and the output station.

In certain embodiments the method comprises forming a plurality of temporary batches of common supports, each batch comprising one or more common supports, and directing each temporary batch to one of: the input station, a process module, a buffering station and the output station.

In certain embodiments the method comprises separating the common supports of a temporary batch and to form another temporary batch wherein each temporary batch of common supports comprises at least one common support not present in at least one other temporary batch of common supports.

In certain embodiments the method comprises continuously forming and separating the common supports of a temporary batch wherein each temporary batch of common supports comprises at least one common support not present in at least one other temporary batch.

In certain embodiments each temporary batch has the same or a different number of common supports.

In certain embodiments the method comprises loading a common support onto a platform mounted on the transfer means at the input station.

In certain embodiments the plurality of processing modules perform the processing steps of deposition, patterning and etching the common support.

In certain embodiments the method comprises receiving one or more common supports into a processing module from any one of: the input station, a buffering station, a further processing module and performing a processing step on one or more of the common supports contemporaneously during the formation of an integrated circuit on the, or each, common support.

In certain embodiments the processing module is operable to perform one of deposition, patterning, etching or cleaning processing steps on a plurality of common supports which are at the same or different stages of the process of formation of an integrated circuit as the other common supports in the plurality of common supports contemporaneously.

In certain embodiments a control means directs the, or each, common support from the input station to the output station through one or more processing unit according to one or both of a changeable pre-programmed protocol and at least one dynamic protocol.

In certain embodiments the control means is operable to select the one changeable pre-programmed protocol from the plurality of changeable pre-programmed protocols.

In certain embodiments the control means is operable to select one or more masks (or reticles) for an integrated circuit design and to direct the appropriate processing module accordingly.

In certain embodiments the at least one dynamic protocol comprises non-sequential direction of the, or each, common support to one or more buffering stations, a deposition module, a patterning module and an etching module. In this way, the, or each common support may diverted from a pre-programmed protocol in which it is set to sequentially move from the input station, to a deposition module, to a patterning module, to an etching module in a repetitive cycle until the IC is formed on the common support and on to the output station according to a pre-programmed set of parameters and conditions.

In certain embodiments the at least one dynamic protocol comprises directing the, or each common support from any one of: the input station, a buffering station, a deposition module, a patterning module, an etching module and an output station to any one of: a buffering station, a deposition module, a patterning module, an etching module and an output station.

Unless otherwise stated, the following embodiments are embodiments of both the first aspect and the second aspect of the invention.

In certain embodiments, said at least one common support is arranged to support each of a plurality of ICs such that a group of terminals on each IC faces away from the common support.

In certain embodiments the common support is substantially flat.

In certain embodiments the common support is rigid.

In certain embodiments the rigid common support is glass, polycarbonate, metal (e.g. stainless steel) or quartz.

In certain embodiments the common support is flexible.

In certain embodiments the flexible common support is a polymer.

More specifically, in certain embodiments the flexible common support comprises one or more of polyimide, polyethylene terephthalate (PET), polyethylene naphthalate (PEN) and polyether ether ketone (PEEK).

In certain embodiments, the flexible common support is carried on a rigid carrier. More specifically, the carrier is glass, polycarbonate or quartz. Alternatively, or in addition, the rigid carrier comprises an electrostatic chuck carrier, or other temporary bonding arrangement.

In certain embodiments the common support is a thin film support.

In certain embodiments of the second aspect, each IC has a nominal upper side, at which a respective group of terminals is provided, and a nominal lower side, the ICs being supported on the common support such that each lower side faces the support and each group of terminals faces away from the common support.

In certain embodiments of the second aspect, each IC has a nominal lower side, at which a respective group of terminals is provided, and a nominal upper side, the ICs being supported on the common support such that each lower side faces the support and each group of terminals faces towards the common support.

In certain embodiments each IC is substantially planar (generally flat) with the respective group of terminals being provided at one face (surface) of the IC.

In certain embodiments the method according to the invention comprises providing (e.g. manufacturing) at least two common supports each having a different integrated circuit design manufactured thereon contemporaneously. In such embodiment, the control means is operable to select one of the plurality of changeable pre-programmed protocols for each of the common supports.

According to a further aspect of the invention there is provided apparatus arranged to implement a method in accordance with the second aspect of the invention.

In certain embodiments, the transfer means comprises a first carriage mounted on one or more rails. More specifically, the transfer means comprises a first carriage mounted on two linear rails. Slide bearings may be provided to assist in the movement of the carriage along the rails.

In certain embodiment the transfer means comprises one or more of: one or more robotic arms, rollers, a rail or rails, chains and a conveyor. More specifically, the rollers, a rail or rails, chains and/or conveyor of the transfer means is a continuous loop.

In certain embodiments the control means is adapted to control the transfer means, common support gripper means, the input station, the output station and each of the plurality of processing modules, to direct (position) the or each common support to its required location in the system. More specifically, the control means is adapted to control the components of the system according to one or more protocols programmed into a processing unit which processing unit is operably linked to the control means.

In certain embodiments, the location of each common support in the system is directed by the control means according to a processing protocol relating to that common support.

In certain embodiments, a processing protocol may comprise one or more of: residence time in the system; transfer time between one or more of: the input station, each processing module and the output station; buffering time in a buffer station.

In certain embodiments the control means is adapted to control the transfer means to translate each common support (i.e. when supported by the transfer means) relative to the input station, the processing modules and the output station.

In certain embodiments, the system comprises a camera. More specifically, the camera is operable to locate each common support.

In certain embodiments the, or each, at least one common support comprises a code (e.g. an alphanumeric code) etched thereon. In this way, the code may be read by any suitable reader (e.g. an OCR barcode reader) or readers in the system. In this way, the location of any common support in the system may be tracked. Alternative approaches to tracking common supports may be used, for example RFID or other approaches providing magnetic, optical or electromagnetic identification.

According to certain embodiments of the invention the system comprises at least two common supports upon which at least two different integrated circuit designs are manufactured contemporaneously.

Another aspect provides apparatus arranged to implement a method according to the invention.

According to a further aspect of the invention there is provided an integrated circuit manufactured in accordance with the method according to the invention.

According to a further aspect of the invention there is provided a plurality of integrated circuits on a common support manufactured in accordance with the method of the invention.

According to a further aspect of the invention there is provided an integrated circuit manufactured in accordance with a method of the invention wherein the method is implemented in a system according to the invention.

According to a further aspect of the invention there is provided a plurality of integrated circuits on a common support manufactured in accordance with the method of the invention wherein the method is implemented in the system according to the invention.

According to a further aspect of the invention there is provided a computer-readable storage medium comprising instructions which, when executed by a computer, cause the computer to carry out the steps of the method of the invention.

According to a further aspect of the invention there is provided a central transfer system for a system for manufacturing a plurality of integrated circuits (IC), according to claim 12.

In certain embodiments the central column assembly comprises a turn-table mechanism adapted to move any one of said at least one storage member rotatably about said longitudinal axis.

In certain embodiments the turn-table mechanism is further adapted to move said central column assembly along said longitudinal axis.

In certain embodiments the central transfer system comprises a plurality of said at least one storage member operably stacked along said longitudinal axis.

In certain embodiments any one of said plurality of at least one storage member is rotatable about said longitudinal axis independently of any adjacent one of said plurality of at least one storage member.

In certain embodiments the central column assembly further comprises an internal handling mechanism configured to receive and move said at least one common support along said longitudinal axis to and from any one of said plurality of at least one storage member.

In certain embodiments the central transfer system further comprises at least one radial transport mechanism adapted to move said at last one common support to and/or from said at least one receptacle.

In certain embodiments the at least one radial transport mechanism is adapted to move said at least one common support between any one of said internal handling mechanism, said at least one receptacle and a processing module.

### BRIEF DESCRIPTION OF THE DRAWINGS

Embodiments of the present invention will now be described with reference to the accompanying drawings of which:
Fig. 1 is a diagrammatic representation of a system embodying the invention and suitable for manufacturing a plurality of integrated circuits;
Fig. 2 is a diagrammatic representation of a further system embodying the invention and suitable for manufacturing a plurality of integrated circuits;
Fig. 3 is a schematic representation of a system embodying the invention and suitable for manufacturing a plurality of integrated circuits; and
Fig. 4 is a schematic representation of a yet further system embodying the invention and suitable for manufacturing a plurality of integrated circuits;
Fig. 5 is a schematic illustration of (a) a top view and (b) a partial side view of a central transfer system operably integrated within a system for manufacturing a plurality of ICs including four process tools operably interfaced with the central transfer system, (c) shows a schematic illustration of the cassettes (holding, for example, one or more wafers) accessible by a respective process tool;
Fig. 6 is a schematic illustration of (a) a top view and (b) a side view of another embodiment of the central transfer system shown in Fig. 5;
Fig. 7 is a schematic illustration of (a) a top view and (b) a side view of yet another embodiment of the central transfer system shown in Fig. 5.

### DETAILED DESCRIPTION

### (i) System(s) and method(s) with conveyor support transfer

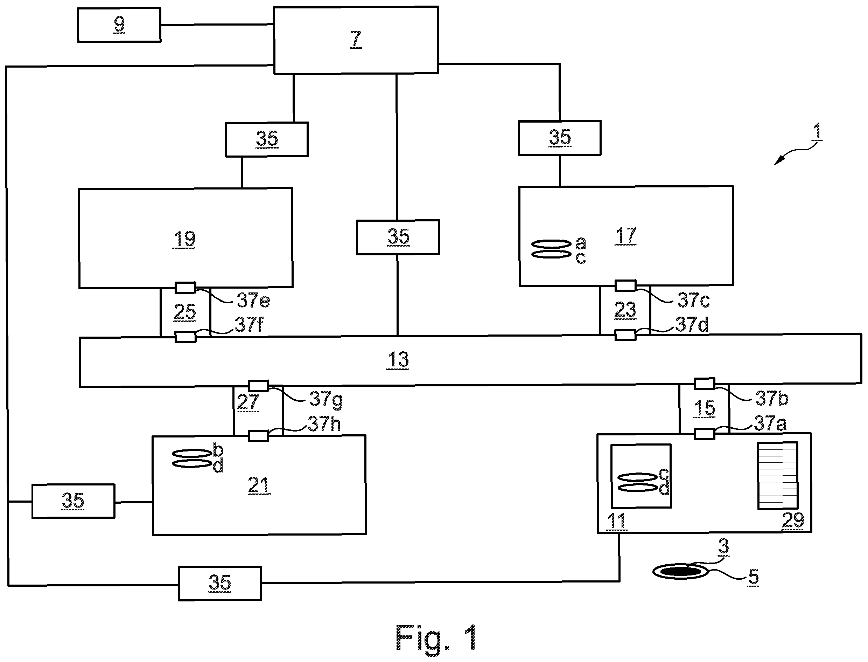

Referring now to Fig. 1 this shows a system, or apparatus, for manufacturing a plurality of integrated circuits, the system or apparatus embodying an aspect of the present invention.

The system 1 comprises a programmable controller 7 operably linked to a user interface 9. An input station 11 is connected to a common support transfer means, being conveyor 13, via a buffering station 15. The conveyor 13 is further connected to a deposition processing module 17, an etching processing module 19, a patterning (or masking) processing module 21 via buffering stations 23, 25 and 27. Each of the input station 11, deposition module 17, etching module 19 and patterning module 21 are linked to the adjacent buffering station 15, 23, 25, 27 by a bidirectional interface which allows a flexible polymer support 3 on a rigid carrier 5 to be transferred between the buffering station and the adjacent station or module (11, 17, 19, 21). In turn, each buffering station is linked to the conveyor 13 by a bidirectional interface which allows a flexible polymer support 3 on a rigid carrier 5 to be transferred between the buffering station and the adjacent conveyor 13. In the depicted arrangement, the input station 11 is also an output station 29 for flexible polymer supports 3 on which a plurality of complete integrated circuits have been formed. The input station 11 and the output station 29 comprise a cassette 31, 33 which provides capacity to hold a number of flexible polymer supports 3 each on a rigid carrier 5. A batch (1or more flexible polymer supports on rigid carriers) of flexible polymer supports/carrier combinations 3, 5 are depicted by reference letters a, b, c, d in inlet cassette 31. The cassette can be a bidirectional cassette. In this way, the flexible polymer supports/carrier combinations 3, 5 can be slotted into the cassette and removed from the cassette from both the front and the rear orientation of the cassette.

It is envisaged that in certain embodiments (not shown), the buffer station to conveyor transfer is performed by a robotic arm, which is operable to move a common support (e.g. wafer) between a platform mounted on the conveyor and a slot in a cassette (e.g. a loading rack) in the buffer station. The buffer station to module transfer is performed by the robotic arm moving a common support (e.g. wafer) between the cassette in the buffer station and a slot in a movable transfer cassette which can be loaded into the module.

The conveyor 13 could be any suitable transport system for moving the supports through the system 13 (e.g. robotic arms, rollers, a rail or rails, chains, a continuous loop conveyor or the like).

In the depicted arrangement a flexible polymer common support 3 is supported on a rigid glass carrier 5 throughout the system. In alternative embodiments, the common support may be a rigid, glass support.

Each bidirectional interface (37a to 37h), under the direction of controller 7, moves one or more common supports 3 from a module (e.g. a deposition 17, etching 19 or patterning 21 module) or the input station 11 to a buffering station 23, 25, 27, 15. Thereafter, a further bidirectional interface moves one or more common supports 3 from the buffering station 23, 25, 27, 15 to the conveyor 13 for transportation to another module or station.

The bidirectional interface (37a, 37b, 37c, 37d, 37e, 37f, 37g, 37h) may comprise a robotic arm or arms operable to pick up one or more common supports 3 and to move same to the next module, station or conveyor 13.

Each module of system 1 is operable to perform one or more processing steps in the formation of layers of an integrated circuit. When each layer is formed, one or more of the modules undertakes its processing step suitable for the formation of a layer of the integrated circuit being formed on the common support 3. During the formation of a complete integrated circuit on a common support 3, each processing module will be active in the formation of one or more layers of the integrated circuit.

The system 1 is operable to carry out multiple processing steps, in multiple processing modules, on multiple common supports 3, contemporaneously.

For each layer of the integrated circuit, each module of the system 1 performs a process step on one or more batches (a, b, c, d) of common supports 3, each batch comprising 1 or more common supports 3 (wafers). Each batch in any one module undergoing a process step may be at a different layer in the integrated circuit formation process to any other batch in the same module at the same time. In this way, batches of common supports 3 can be brought together into a temporary batch (a, c in module 17 and b, d in module 21) to undergo the same processing step in the same module at the same time. The temporary batch so formed may then be separated under the direction of the controller 7 to form further temporary batches comprising 1 or more common supports 3. The further temporary batches are then transported, using conveyor 13, to a buffering station 15, 23, 25, 27 in preparation for the next module and processing step or output from the system 1 and output station 29. The further temporary batches may each be formed of the same or different common supports 3 to the previous temporary batch.

Each module is operated under the direction of controller 7. The controller 7 comprises a processor (e.g. a microprocessor, CPU or the like) which is programmed with scheduling logic providing instructions for a processing protocol. The processing protocol sets out the rules to govern the journey of a common support 3 through the system 1 during the formation of an integrated circuit on the common support 3.

The processing protocol comprises a sequence of processing steps, together with processing parameters and operating parameters which when implemented by the controller 7 on the system 1, builds one or a plurality of integrated circuits vertically on each common support 3 in the system 1.

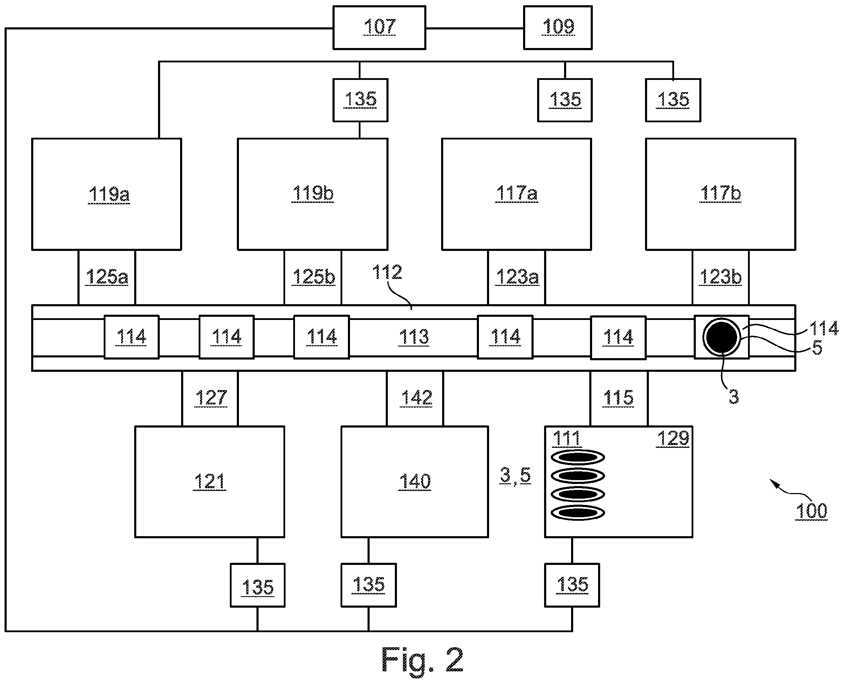

The sequence of processing steps in the processing protocol is pre-programmed to include a sequence of deposition, patterning and etching. The sequence may also include a baking and a cleaning step. The cleaning step in the pre-programmed protocol follows the etching step in the sequence. The baking step in the pre-programmed protocol follows the deposition step in the sequence (see Figure 2).

The processor is programmed with a plurality of pre-programmed protocols, each providing instructions for the formation of one or a plurality of integrated circuits vertically on each common support 3 in the system 1. The controller 7 is operable to select one pre-programmed protocol to run on the system, the protocol describing the integrated circuit product to be manufactured. In this way, a range of products can be programmed into the system (that is a number of pre-programmed protocols) at any one time.

The processing parameters of the processing protocol comprise, for example, one or more recipes for each layer (e.g. semiconductor, insulator, gate, source-drain, electrical interconnection layers) of an integrated circuit, the temperatures and pressures at which each component of the system is operable.

The operating parameters of the processing protocol comprise, for example, dwell time of a common support 3 in the system, a module or a station, a prioritisation logic allowing one or more common supports to have decreased transit time through the system relative to other common supports in the system, system/module/station population control, module diversion logic to allow the sequence of processing through the system to be changed from the pre-programmed protocol, maximum dwell times and minimum process time for a high priority common support 3. It will be understood that additional operating parameters are envisaged to be set out in a processing protocol and be within the control of controller 7 during implementation of the processing protocol.

In order to provide the operational flexibility required to efficiently process a high volume of common supports, the processing protocol may comprise a dynamic protocol. In the dynamic protocol the controller 7 is programmed to allow the sequence of processing steps through the system and/or the processing parameters and/or the operating parameters to be changed from the pre-programmed protocol. A dynamic protocol may be initiated for one or more common supports 3 at any one time. More than one dynamic protocol may be initiated for one or more common supports 3 at any one time.

The controller 7 can initiate a dynamic protocol to override the pre-programmed protocol for any one or more of the common supports 3 in the system 1. A dynamic protocol can be initiated in response to feedback and/or monitoring in the system. Such feedback or monitoring can be provided by tracking the one or more of the common supports 3 in the system 1 to monitor one or more of the operating and processing parameters applicable to the one or more of the common supports 3. For example, if a common support 3 is monitored for transit time in the system and same is deemed to exceed the required time, a dynamic protocol can be initiated by the controller 7 for that common support 3 to prioritise it above all other common supports 3 in the system 1. In this way, the system is operable to change the processing steps and/or operating and/or processing parameters applicable to the one or more of the common supports 3 at any time under the direction of the controller 7. In this way, the transit of each common support 3 through the system 1 can be dynamically controlled independently of any other common support in the system. In addition, batches of 1 or more common supports 3 may be processed according to one or more dynamic protocols during transit through the system 1. Each batch may be temporarily formed, may undergo a dynamic protocol, before being separated. Thereafter, each common support 3 of that temporary batch, may form one or more further temporary batches.

In operation of the system 1, controller 7 is programmed with a pre-programmed protocol setting out a sequence of processing steps, together with processing parameters and operating parameters which when run, control the components of the system 1 during the formation of a plurality of integrated circuits on the or each common support 3 in the system 1. At any time during its transit through system 1, the controller 7 is operable to override the pre-programmed protocol and to initiate a dynamic protocol for handling (i.e. processing) the common support 3 for at least a part of the remaining transit through the system. The controller may initiate one or more dynamic protocols at any time during the transit of a common support through the system 1. Each common support 3 is allocated a place in the system 1 which it retains as it is transported through the system 1 and processed according to a processing protocol comprising a pre-programmed protocol and one or more dynamic protocols. In this way, the processing protocol for a common support 3 as it transits through the system 1 will comprise a series of protocols (pre-programmed and dynamic). The controller 7 (i.e. the process control system) knows where a common support 3 is at all times in the system 1 and can prioritise its processing according to the relevant processing protocol comprising a pre-programmed protocol and one or more dynamic protocols. The processing protocol controls, for example, whether the common support 3 is moved to a buffering station 15, 23, 25, 27, to another module (11, 17, 19, 21) or to the output station 29 to exit the system 1.

The controller 7 is programmed with software encoding a processing protocol which when executed initiates a processing protocol (a set of processing steps, operating parameters and processing parameters) for one or more common supports 3 in the system 1 at any one time. A primary level of system priority control is provided by the controller 7 being programmed with a master job schedule which sets out at least a structure of the integrated circuits to be formed on the common support 3. The master job schedule will also include a changeable pre-programmed protocol which, when initiated by the controller 7 sets the instructions for each of the components of the system 1 to form the integrated circuit design set in the master job schedule. According to the changeable pre-programmed protocol, one or more common supports 3 are transported through the system 1, 100 according to a predetermined series of processing steps in the processing modules and according to a pre-determined set of operating and processing parameters in each system component so as to form a plurality of integrated circuits on the common support 3.

In the embodiment depicted in Figures 1, 2 and 3, the controller 7, 107, 307 is operably linked to a series of sub controllers 35, 135. Each sub controller 35, 135 in turn is operable to initiate the pre-programmed protocol (instructions) as it relates to the module/station with which it is operably linked. Each sub-controller 35, 135 comprises a processor (microprocessor or the like) operable to relay the operating and processing conditions of the module/station to which it is linked, back to the controller 7, 107, 307. In a second level of priority control, the controller 7, 107, 307 and sub-controllers 35, 135 are operable to initiate one or more dynamic protocols in which one or more processing or operating parameters of the module/station is changed from the pre-programmed protocol in response to the operating and processing conditions of the module/station.

Initiation of a dynamic protocol by the controller 7, 107, 307 and sub-controllers 35, 135 overrides the pre-programmed protocol to initiate a change in one or more operating or processing parameters. Examples of those parameters include: module dwell time, system dwell time, next module transfer, buffering station dwell time, system population, module population, buffering station population, output station population, and input station population.

A dynamic protocol may be initiated and/or run by one or more sub-controllers 35 under the direction of controller 7 for one or more common supports 3. At each station/module point, a common support will have different secondary priority depending on different parameters from other common supports in the system. In this way, each common support 3 can be processed independently of any other common support 3 in the system 1. For example, one common support 3 may be processed urgently according to a dynamic protocol in which system transit time is reduced compared to the system transit time of the pre-programmed protocol which governs the transit time of other common supports 3 in the system 1 at the same time.

In the depicted example, the common support is a flexible polymer. The system 1 is operable according to a processing protocol which defines the processing instructions and the operating and process parameters for the system and its components according to which protocol a plurality of integrated circuits (ICs) are vertically layered onto a common support 3 deposited on a rigid glass carrier 5. The system 1 operates according to the processing protocol to form layers of a plurality of integrated circuits on the common support 3 until a plurality of complete ICs are formed thereon. The ICs may be plastic film-based ICs, initially provided in a flat array of such devices on a glass carrier plate or common support.

If the system 1 is populated with common supports 3 upon which different circuit designs are to be layered to form different integrated circuits, the sub-controller 35 of the patterning module 21, for example, directs the module to select the correct pattern for a batch of common supports 3 loaded into the patterning module 21. Following processing according to the selected pattern, the batch of common supports 3 are transported back to the conveyor 13 before a further batch of common supports is loaded into the patterning module 21 and processing according to a further pattern (different from the first) is initiated by sub-controller 35. The controller 7 knows the location of each common support 3 in the system 1 and can, therefore, direct the correct common support(s) 3 to the patterning module 21 at the right time to receive the correct circuit pattern. Similar control may be performed over other modules in the system, for example the deposition and/or etching modules.

The controller 7 is operable to direct each common support 3 in the system 1 and to instruct the system 1 to move the common support 3 to a station or module according to the processing protocol applicable to that common support. During its transit through the system 1, each common support 3 can form part of multiple batches (e.g. groups of 1 or more common supports). A temporary batch of common supports can be formed at the direction of the controller at each station and/or module in the system. Each temporary batch can vary in size and composition at one or more stages in the process.

As shown in Figure 2, the system 100 comprises patterning 121, deposition 117a, 117b, etching 119a, 119b and baking 140 modules, a combined input/output station 111, 129, a common support transport means 113 formed of conveyor 112 (e.g. rollers, a rail or rails, chains, a continuous loop conveyor or the like) and sliding carriages 114 each carriage 114 being slidable with respect to conveyor 112 and configured to carry a flexible common support 3 on a carrier 5, and buffer stations 115, 123a, 123b, 125a, 125b, 127, 142.

In the depicted embodiment, etching modules 119a and 119b may provide enhanced etching capabilities over single etching module 19. For example the multiple etching modules may provide additional capacity or throughput, or a greater range of etching techniques. Etching modules 119a and/or 119b may each perform wet and/or dry (plasma) etching, or other techniques known in the art. Deposition modules 117a and 117b may provide enhanced deposition capabilities over single deposition module 17. For example the multiple deposition modules may provide additional capacity or throughput, or a greater range of deposition techniques. Deposition modules 117a and/or 117b may each perform physical vapour deposition (PVD), chemical vapour deposition (CVD), electrochemical deposition (ECD), molecular beam epitaxy (MBE), atomic layer deposition (ALD), printing, and/or other techniques known in the art. The patterning module 121 may, for example, be a combined CBD (coat, bake, develop) and photolithography (exposure) module which comprises two sub-units within one module 121, one for CBD and the other for photolithography. Alternatively multiple patterning modules may be employed, analogously to the etching and deposition modules described above. Other patterning techniques may be provided by patterning module 121 or by further patterning modules, for example electron beam lithography, x-ray lithography, ion beam lithography, printing, and/or other techniques known in the art.

The baking module 140 is an oven that can be used to anneal at one or more particular steps of the process sequence. This could optionally include other treatments such as IR heating, photonic treatment (e.g. UV) or rapid thermal annealing. In the depicted embodiment the baking module is shown as a separate module. Alternatively, or additionally, such baking or other thermal or photonic treatments may be performed within one or more of the other modules in the system.

The Input / Output station 111/129 is a combination common support 3 loading, unloading station with an identification reader module (not shown) that may also contain an alignment and measuring inspection unit.

In the depicted embodiment, the common support transfer means is a conveyor module 112 comprising a rail. Carriages 114 are mounted on and slidable relative to the rail 112 and carry a flexible polymer support 3 on a rigid glass carrier 5. In alternative arrangements, not shown, each carriage 114 may transport a cassette of common supports along rail 112 to any one of the buffering stations 115, 123a, 123b, 125a, 125b, 127, and 142. In embodiments, not shown, the conveyor 112 can comprise rollers, a rail or rails, chains, a continuous loop conveyor or the like.

Common supports 3 are transferred from the carriages 114 to the buffering stations 115, 123a, 123b, 125a, 125b, 127, 142 by any suitable bidirectional interface, such as for example a robotic arm or the like. The buffering stations 115, 123a, 123b, 125a, 125b, 127, 142 are transit stations for common supports 3 moving between the carriages 114 and the modules 111, 117a, 117b, 119a, 119b, 121, 140 and 129.

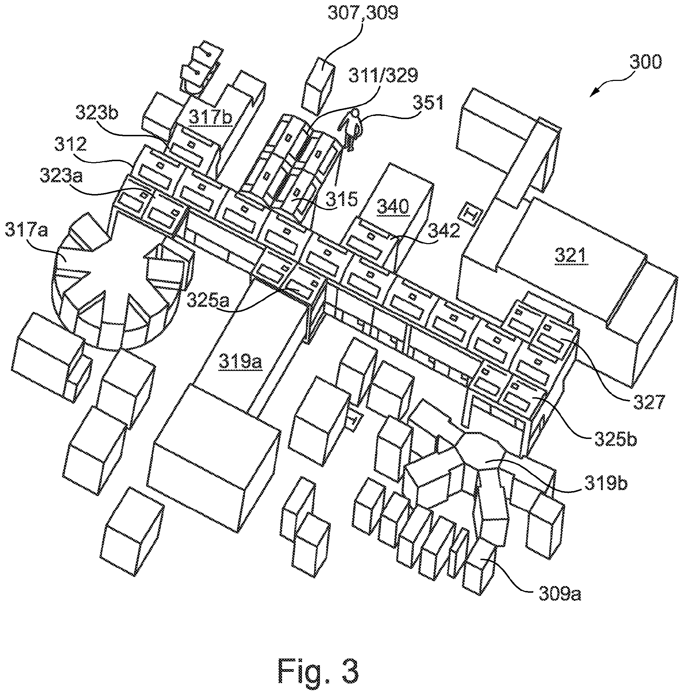

Figure 3 shows a system 300 for manufacturing a plurality of integrated circuits, the system or apparatus embodying an aspect of the present invention.

The system 300 is similar to the system depicted in Figure 2 in that it comprises a combined input and output station 311/329 and a conveyor 312 forming a transfer means for flexible polymer supports (not shown) loaded into and moved through the system 300 on rigid glass carriers (not shown). The conveyor 312 could be any suitable transport system for moving the supports through the system 300 (e.g. rollers, a rail or rails, chains, a continuous loop conveyor or the like).

Buffering stations 315, 323b, 323a, 325a, 325b, 327 and 342 connect input/output station 311/329, deposition modules 317b, 317a, etching modules 319a, 319b, patterning module 321 and baking module 340 respectively with the transfer conveyor 312. In this way, flexible polymer supports can be moved into and out of the stations and modules and along conveyor 312 under the direction of controller 307 with user interface 309. In the depicted arrangement, a further user interface 309a is provided at the opposite side of the system 300 such that the user 351 has no need to work around the system 300 to interact with the user interface. Both user interfaces 309, 309a are operably linked to controller 307.

Deposition module 317a and etching module 319b each comprise a cluster of sub-modules. Each sub-module within the deposition module 317a may be operable to deposit a single material layer onto the common supports. Similarly, each sub-module within the etching processing module 319b is operable to etch one or more layers of the integrated circuits to be formed on the common supports.

Each cluster of sub-modules (317a, 319b) comprises a plurality of robotic arms (not shown) to move common supports between sub-modules and into and out of the processing modules (317a, 319b) onto the transfer conveyor 312.

User 351 inputs a processing protocol comprising a master job schedule and a pre-programmed protocol into controller 307 using user interface 309, 309a. Controller 307 is operable to initiate a processing protocol for a flexible polymer support (not shown) loaded into input station 311 according to the instructions provided in the master job schedule and the pre-programmed protocol. The controller 307 tracks the flexible polymer support through system 300 and is operable to initiate one or more dynamic protocols to override the pre-programmed protocol in respect of that flexible polymer support to change one or more of: the sequence of processing steps, processing parameters and operating parameters applicable to the common support. In this way, any one flexible polymer support in system 300 is directed through the system 300 by the controller 307 according to a processing protocol (set of processing instructions) comprising a pre-programmed protocol and at least one dynamic protocol.

The flexible polymer support is repetitively cycled through elements of the system 300 in order to vertically build layers of a plurality of integrated circuits in each cycle until the complete integrated circuits are formed on the flexible polymer support, according to a design set out in the master job schedule.

### (ii) System and method utilising a central column support transfer

Despite the advantages of the conveyor belt system(s) 1, 100, 300, wafer transfer on such a linear racetrack may not pass or overtake each other when transported between process tools (such as modules 17, 19, 21). Some process tools, for example those which process multiple wafers (e.g. common supports 3, in batches) may take a significant amount of time to unload onto the racetrack (e.g. conveyor 13, 113, 312), during which time the other wafers on the track cannot be moved. These issues can decrease the efficiency of the manufacturing process due to accumulated time delays. Such linear conveyors (e.g. 13, 113, 312) also consume considerable amounts of electrical power, therefore increasing IC production costs. Furthermore, the relatively large physical size of the racetrack may require a proportionally large volume of clean air in which to operate, which in turn demands a larger, more costly clean air system.

Consequently, an alternative embodiment to systems having a linear racetrack (i.e. system embodiments 1, 100, 300) may utilise a central column or carousel of buffer cassettes (or other wafer-holding receptacles) having locations for supporting wafers on multiple levels.

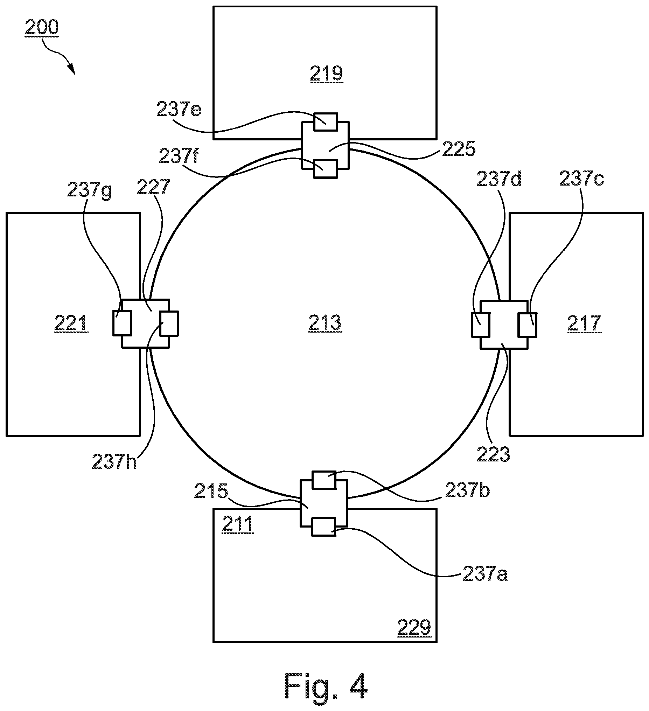

Figure 4 shows a system 200 for manufacturing a plurality of integrated circuits, the system 200 or apparatus embodying an aspect of the present invention. The depicted arrangement is similar to the system illustrated in Figure 1 with the exception that the conveyor 13 is replaced by a central carousel 213. The carousel 213 is connected to buffering stations 215, 223, 225, 227 by bidirectional interfaces (e.g. robotic arms) 237b, 237d, 237f and 237h, respectively, such that flexible polymer supports (not shown) on glass carriers (not shown) (e.g. wafers) loaded into input station 211 are transferrable to and from the carousel 213 by the bidirectional interfaces (e.g. robotic arms). Further bidirectional interfaces (e.g. robotic arms) 237a, 237c, 237e, 237g are operable to transfer the rigid glass carriers supporting the flexible polymer supports (not shown) from the buffering stations 215, 223, 225, 227 to a deposition module 217, an etching module 219 and a patterning module 221 respectively.

The central carousel 213 provides for a further buffering station in which one or more common supports (e.g. wafers) may be temporarily resident before the controller (not shown) directs same to one of the buffering stations 215, 223, 225, 227.

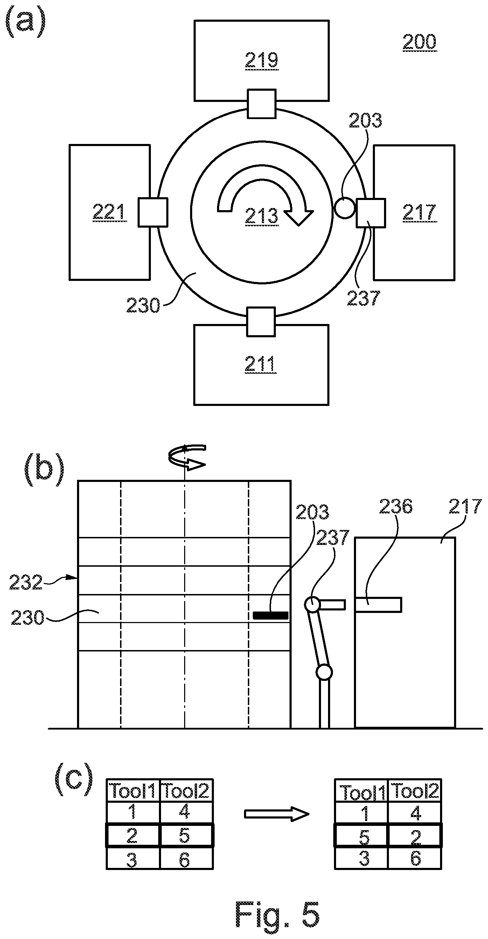

In particular, and as illustrated in Figures 5, 6 and 7, the column or carousel 213 may be attached to a turn-table (not shown) and the tools (e.g. a processing module, such as, any one of modules 211, 217, 219, 221) are mounted around the outside of the column or carousel 213. An interface robot 237 may be provided to transfer wafers 203 or cassettes between each tool 211, 217, 219, 221 and the buffer cassette or buffer 230. As wafers 203 need to progress to the next tool 211, 217, 219, 221, the turn-table indexes around. Each interface robot 237 will need a larger vertical (i.e. Z) motion than what is required with the racetrack (i.e. conveyor 13, 113, 312) in order to reach all levels 232 of the column 213. The buffer's 230 capacity is distributed among buffer receptacles such as cassettes, each having one or more locations for supporting the wafers. For example, there may be as many as fifty locations within each cassette, and cassettes may be arranged in one or more vertical storeys, such as, for example, buffer levels 232. The interface robots 237 transport wafers 203, or cassettes containing one or more wafers 203, between the buffer 230 and the process tools 211, 217, 219, 221 via transfer ports in the tools 211, 217, 219, 221. A single interface robot 237 may transfer wafers 203 between the column 213 and more than one process tool 211, 217, 219, 221. The one or more process tools 211, 217, 219, 221 may comprise additional internal buffer capacity.

A further enhancement to the carousel 213 would be to have each buffer (cassette) 'level' 232 operable on its own rotation mechanism, so that a cassette full of wafers 203 can proceed around to the next tool (e.g. any one of process tools 211, 217, 219, 221). This possibly becomes most manageable by having a level 232 or "shelf' assigned to each layer of the IC stack and as wafers 203 finish one IC stack layer they move up to the next level (shelf) etc. This approach may limit the Z-axis translation distance (i.e. vertical movement) required of some tool transfer robots, since they may only need to address two neighbouring levels of the column of buffer levels 232. However, it may reduce potential time delays in the handling system. For example, as illustrated in Figure 5 (c), wafers 203 may be arranged in cassettes (e.g. 1, 2, 3) that are accessible by a first processing tool (e.g. tool 1) and cassettes (e.g. 4, 5, 6) that are accessible by a second processing tool (e.g. tool 2). After some processing time, wafers 203 in cassette 2 may be finished on tool 1, and wafers 203 in cassette 5 may be finished on tool 2. The handler is adapted to move respective cassettes (i.e. buffers) around to the next location (e.g. swap process tools 1 and 2).

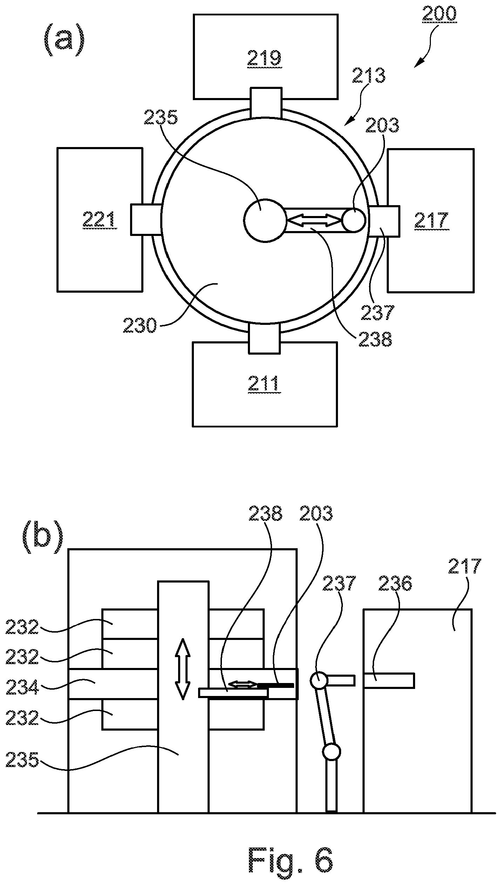

Referring now to Figure 6, an alternative to the enhanced carousel 213 illustrated in Figure 5 may be to introduce an internal wafer handling system 235 into the column (i.e. carousel 213). The internal wafer handling system 235 is configured to transport wafers 203 (or cassettes comprising one or more wafers 203) to and from the carousel 213 via the tool interface robots 237 at one or more transfer levels 234 of the column 213. In the event that the vertical positions (i.e. heights) of all process tool transfer ports 236 are equal or at least similar, then only a single transfer level 234 may be required. However, a varying range of the process tool transfer port 236 heights may necessitate more than one transfer level 234, which may either be adjacent to each other or be separated by one or more buffer levels 232. During use, upon reception of a wafer 203 (or cassette comprising one or more wafers 203) by a slot on a transfer level 234, the column's 213 internal handling system 235 moves the wafer 203 to a buffer level 232 whilst it awaits transfer to another process tool 211, 217, 219, 221. At a predetermined time, the wafer 203 may be moved within the column 213 to a slot on a predetermined transfer level 234, from where it may be picked up by a respective interface robot 237. The internal handling system 235 may further comprise at least one vertical and/or radial transport mechanism 238 adapted to transport one or more wafers 203 at a time. In order to position respective wafers 203 for pick-up by a corresponding interface robot 237, the wafers may be moved about the column 213 by either one of:
(i) Rotation of the or each transfer level 234 of the column 213, and/or
(ii) Rotation of the internal handling system 235.

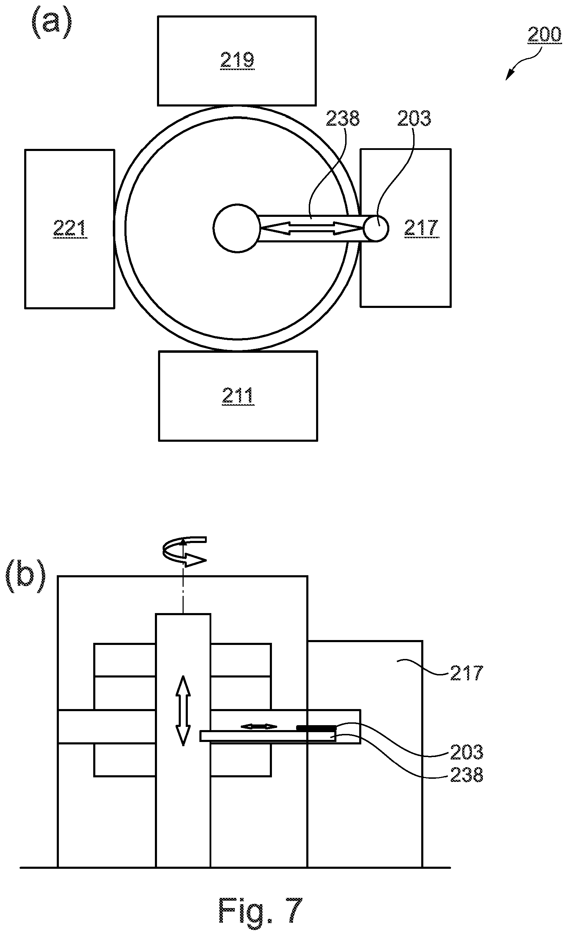

Figure 7 shows an alternative implementation to the embodiment illustrated in Figure 6 (i.e. including an internal handling system 235) may provide for a reduced number of interface robots 237 to be used. In fact, the alternative embodiment may be configured so as to eliminate the need for any interface robots 237. For example, the carousel's 213 internal handling system 235 may be adapted to provide extended radial reach, therefore, allowing direct wafer exchange (i.e. carriers) with at least some or all of the process tools 211, 217, 219, 221. Such wafer exchanges may take place on one or more transfer levels 234 depending on the vertical positions of the process tool transfer ports 236. Suitable internal wafer handling systems 235 are known in the art (e.g. employing robotic arms) and are therefore not discussed in any more detail.

A system 200 with a central rotational column (i.e. carousel) 213 may provide at least some advantages over a system utilising, for example, race-track type conveyor transport system. The advantages may be:
- Potential reduction of buffer unit footprint space per tool by having a centralised system.
- Race-track conveyor is replaced by a turn-table mechanism;
- Potential reduction of footprint of the overall system due to the more compact circular format, this may also reduce installation costs, since the supply routing between tools can be made shorter.
- Movement by cassette may increase batch production efficiency, for example, a stack of wafers may be moved on to the next tool as a whole, as opposed to individual wafers that are moved via the conveyor system. This may also improve cleanliness potentially having an impact on the requirements of the clean air system.
- Complexity of scheduling systems may be reduced (especially photolithography loading and the recording of wafers in buffers).
- System wafer capacity may be increased without increasing the system footprint, for example, the column may simply be made taller and/or the spacing between wafers may be reduced to increase number of wafers that can be accessed.

### (iii) System(s) and method(s) for other products:

Although the systems and methods are described herein in the context of the manufacture of ICs, the same systems and methods are equally applicable to the manufacture of a range of products. For example, the same cycle of deposition, patterning and etching may be employed to manufacture electronic components, such as capacitors, resistors, inductors, transistors, diodes etc., in 'discrete' or other forms that would not be considered integrated circuits. One specific example is a thin film capacitor, formed by precision lithographic techniques using appropriate process tools. Such precision capacitors, which may be formed at low temperature on flexible substrates, have many potential applications, for example in wearable electronics, health monitoring and medical devices. One or more common supports may be inserted into the system and components may be formed upon those common supports alongside other common supports upon which ICs are being formed. In one process tool one or more 'component common supports' may be processed at the same time and/or under the same conditions as one or more 'IC common supports'. Component common supports may be prioritised differently from IC common supports in order to optimise tool population control or utilisation, transit time through the system, system efficiency, etc. Alternatively, both components and ICs may be formed on the same common support, which may be prioritised accordingly.

The term Integrated Circuit (IC) used in this disclosure may be interpreted very broadly, and the nature of ICs and other products manufactured by the systems and methods described may be extremely diverse. Any item comprising an electronic component and exhibiting some electronic activity is in scope. ICs may include but are not limited to digital ICs, analogue ICs, mixed-signal ICs, microprocessors, digital signal processors (DSPs), logic ICs, microcontrollers, interface ICs, programmable logic devices, application-specific ICs (ASICs), RFID ICs, RF ICs, memory ICs, sensors, power management circuits, operational amplifiers, data acquisition ICs, clock/timing ICs, etc.

A common support may be in the form of a partially-manufactured substrate, as an alternative to the 'plain' glass or silicon wafers previously mentioned. Examples may include a partially-manufactured silicon wafer comprising a plurality of partially-manufactured silicon ICs. Further steps in the manufacture of those silicon ICs may be performed flexibly in the systems, or using the methods, described. Other examples include partially-manufactured displays, batteries or sensors. One or more such partially-manufactured substrates, or common supports, may be inserted into the system whilst it is also manufacturing ICs or other products onto 'plain' glass common supports. The partially-manufactured common supports may be processed at the same time and/or under the same conditions as one or more 'IC common supports'. Partially-manufactured common supports may be prioritised differently from IC common supports in order to optimise tool population control or utilisation, transit time through the system, system efficiency, etc., or simply to run trials of one product type at the same time as mass production of a second product type.

More complex products may also be manufactured. For example, hybrid systems, in which components manufactured by other processes and ICs, manufactured in the present system and/or by other processes, are incorporated.

### (iv) Supplemental information

It should be understood that in certain embodiments of systems 1, 100, 200 and 300, one or more of the buffering stations can be removed to provide for direct transfer of the, or each, common support for the transfer means to a module and/or the input/output station.

It should be further understood that the input and output stations can be separate stations in any of the systems 1, 100, 200, 300 depicted herein.

The system 1, 100, 200, 300 may optionally be enclosed in a microenvironment (not shown). In this way, the temperature, humidity and airborne particulate count, for example, of the system environment can be monitored and controlled.

The transfer means (e.g. conveyor 13, pair of rails 113, 212a, 212b carousel 213) may operate at up to 5 ms⁻¹.

The controller 7, 107, 307 is operable to provide automated common support transfer through the system 1. This allows the system 1 to operate with minimal or no human intervention other than with the user interface 9, 109, 309, which may be positioned at a location remote from the other components of system 1.

It is envisaged that the system provides for a so-called "hot swap" of processing modules. In a "hot swap" condition, the system comprises an additional module space. More specifically, the spare module space allows a new module to be introduced or faulty or maintenance-due modules to be replaced without halting production. The controller is operable to direct the at least one common support to a processing module (or sub-module) in the spare module position as required.

Throughout the description and claims of this specification, the words "comprise" and "contain" and variations of them mean "including but not limited to", and they are not intended to (and do not) exclude other moieties, additives, components, integers or steps. Throughout the description and claims of this specification, the singular encompasses the plural unless the context otherwise requires. In particular, where the indefinite article is used, the specification is to be understood as contemplating plurality as well as singularity, unless the context requires otherwise.

The invention is defined by the appended claims. Various embodiments may be considered as long as they belong to the scope of the invention which is defined by the appended claims.

## Claims

1. A system (1) for manufacturing a plurality of integrated circuits, ICs, mounted on a flexible common support, the system comprising:
an input station (11) configured to receive at least one flexible common support (3), each flexible common support being on a respective rigid carrier (5);
an output station (29) configured to receive the at least one flexible common support on the respective rigid carriers after a plurality of ICs are formed on the at least one flexible common support;
a plurality of processing modules (17, 19, 21), each processing module being operable to perform at least one processing step for forming the ICs on the at least one flexible common support whilst on the respective rigid carriers;
a transfer means (13) operable to transfer the at least one flexible common support on the respective rigid carriers from the input station to the output station and to one or more of the processing modules therebetween;
control means (7) operable to direct the at least one flexible common support on the respective rigid carriers from the input station to the output station through one or more of the plurality of processing modules according to at least one processing protocol comprising a plurality of changeable pre-programmed protocols;
the control means being operable to direct the movement of a flexible common support on the respective rigid carrier from the input station to the output station and through one or more of the processing modules independently of any other flexible common support on the respective rigid carrier,
wherein each flexible common support is maintained on the respective rigid carrier throughout the system.

2. A system according to claim 1, wherein the control means comprises a system controller and a plurality of sub-system controllers operable to direct the system and each of the input station, the output station, a buffering station and the processing modules respectively.

3. A system according to claim 1, wherein the control means is operable to select one of the plurality of changeable pre-programmed protocols for the at least one processing protocol.

4. A system according to any preceding claim, wherein the changeable pre-programmed protocol comprises sequential direction of the, or each, flexible common support on the respective rigid carrier to at least a deposition module, a patterning module and an etching module, and/or optionally wherein the changeable pre-programmed protocol includes a repeatable sequence of processing steps for the formation of layers of an IC on a flexible common support, and/or further optionally wherein the at least one processing protocol comprises at least one dynamic protocol.

5. A system according to any one of the preceding claims, wherein the transfer means comprises one or more support moving devices, optionally wherein the one or more support moving devices comprise a plurality of robotic arms operable to move at least one flexible common support on the respective rigid carrier within a module, from one module to another module, to or from a station and/or to and/or from a buffering station, further optionally wherein the plurality of robotic arms are each operable to move a batch loading device configured to receive one or more flexible common supports on the respective rigid carriers, or wherein the plurality of robotic arms are each operable to directly move one or more flexible common supports on the respective rigid carriers.

6. A system according to any one of the preceding claims, wherein each processing module comprises one or more sub-modules.

7. A system according to claim 6, wherein each sub-module within a processing module is operable to perform one of the processing steps in the formation of an IC.

8. A system according to claim 6 or claim 7, wherein a sub-module is operable to form at least one layer of an IC on a flexible common support.

9. A system according to any one of the preceding claims, comprising one or more masks for each of a plurality of IC designs.

10. A method of manufacturing a plurality of integrated circuits, ICs, mounted on a common support, the method comprising:
providing at least one flexible common support (3), each flexible common support being on a respective rigid carrier (5);
providing an input station (11) into which the at least one flexible common support on the respective rigid carriers is loaded;
providing an output station (29) into which the at least one flexible common support on the respective rigid carriers are received after a plurality of ICs are mounted on the at least one flexible common support;
providing a plurality of processing modules (17, 19, 21), each processing module being operable to perform at least one of the steps for forming an IC on the at least one flexible common support whilst on the respective rigid carriers;
providing a transfer means (13) operable to transfer the at least one flexible common support on the respective rigid carriers from the input station to the output station and to one or more of the processing modules;
directing each of the at least one flexible common support on the respective rigid carriers from the input station to the output station through one or more of the plurality of processing modules according to a processing protocol comprising a plurality of changeable pre-programmed protocols;
directing the processing steps of each process module; and
directing the movement of each flexible common support on the respective rigid carrier from the input station to the output station and to one or more of the processing modules independently of any other flexible common support on the respective rigid carrier,
wherein each flexible common support is maintained on the respective rigid carrier throughout the method.

11. A method according to claim 10, comprising selecting one changeable pre-programmed protocol from the plurality of changeable pre-programmed protocols for the at least one processing protocol, and optionally comprising selecting one or more masks for an IC design.

12. A central transfer system (200) for a system for manufacturing a plurality of integrated circuits (ICs), comprising:
a central column (213) assembly having a longitudinal axis;
at least one storage member, mounted operably to and coaxially with said longitudinal axis of said central column assembly, comprising at least one receptacle configured to receive and store at least one flexible common support (3), each flexible common support being on a respective rigid carrier (5); and wherein said central column assembly is configured to move any one of said a least one storage member rotatably about and/or linearly along said longitudinal axis, so as to provide any one of said at least one receptacle at a predetermined processing module (211, 217, 219, 221) of the system for manufacturing a plurality of ICs, and wherein said central column assembly further comprises an internal handling mechanism configured to receive and move said at least one common support on the respective rigid carrier along said longitudinal axis to and from any one of said plurality of at least one storage member.

13. A central transfer system according to claim 12, wherein said central column assembly comprises a turn-table mechanism adapted to move any one of said at least one storage member rotatably about said longitudinal axis, optionally wherein said turn-table mechanism is further adapted to move said central column assembly along said longitudinal axis.

14. A central transfer system according to claim 12 or claim 13, comprising a plurality of said at least one storage member operably stacked along said longitudinal axis, optionally wherein any one of said plurality of at least one storage member is rotatable about said longitudinal axis independently of any adjacent one of said plurality of at least one storage member.

## Patentansprüche

1. System (1) zum Herstellen einer Vielzahl von integrierten Schaltungen, ICs, die auf einem flexiblen gemeinsamen Träger montiert sind, das System umfassend:
eine Eingangsstation (11), die konfiguriert ist, um mindestens einen flexiblen gemeinsamen Träger (3) aufzunehmen, wobei jeder flexible gemeinsame Träger auf einem entsprechenden starren Träger (5) ist;
eine Ausgangsstation (29), die konfiguriert ist, um den mindestens einen flexiblen gemeinsamen Träger auf den jeweiligen starren Trägern aufzunehmen, nachdem eine Vielzahl von ICs auf dem mindestens einen flexiblen gemeinsamen Träger gebildet worden ist;
eine Vielzahl von Verarbeitungsmodulen (17, 19, 21), wobei jedes Verarbeitungsmodul betrieben werden kann, um mindestens einen Verarbeitungsschritt zum Bilden der ICs auf dem mindestens einen flexiblen gemeinsamen Träger auszuführen, während er auf den jeweiligen starren Trägern ist;
eine Transfereinrichtung (13), die betrieben werden kann, um den mindestens einen flexiblen gemeinsamen Träger auf den jeweiligen starren Trägern von der Eingangsstation zu der Ausgangsstation und zu einem oder mehreren der Verarbeitungsmodule dazwischen zu transferieren;
Steuereinrichtungen (7), die betrieben werden können, um den mindestens einen flexiblen gemeinsamen Träger auf den jeweiligen starren Trägern durch eines oder mehrere der Vielzahl von Verarbeitungsmodulen gemäß mindestens einem Verarbeitungsprotokoll, umfassend eine Vielzahl von veränderbaren vorprogrammierten Protokollen, von der Eingangsstation zu der Ausgangsstation zu leiten;
wobei die Steuereinrichtungen betrieben werden können, um die Bewegung eines flexiblen gemeinsamen Trägers auf dem jeweiligen starren Träger unabhängig von jedem anderen flexiblen gemeinsamen Träger auf dem jeweiligen starren Träger von der Eingangsstation zu der Ausgangsstation und durch eines oder mehrere der Verarbeitungsmodule zu steuern,
wobei jeder flexible gemeinsame Träger während des gesamten Systems auf dem jeweiligen starren Träger gehalten wird.

2. System nach Anspruch 1, wobei die Steuereinrichtungen eine Systemsteuerung und eine Vielzahl von Teilsystemsteuerungen umfassen, die betrieben werden können, um das System und jede von der Eingangsstation, der Ausgangsstation, einer Pufferstation und den Verarbeitungsmodulen zu steuern.

3. System nach Anspruch 1, wobei die Steuereinrichtungen betrieben werden können, um eines aus der Vielzahl der veränderbaren vorprogrammierten Protokolle für das mindestens eine Verarbeitungsprotokoll auszuwählen.

4. System nach einem der vorherigen Ansprüche, wobei das veränderbare vorprogrammierte Protokoll die sequentielle Leitung des oder jedes flexiblen gemeinsamen Trägers auf dem jeweiligen starren Träger zu mindestens einem Abscheidungsmodul, einem Strukturierungsmodul und einem Ätzmodul umfasst, und/oder optional wobei das veränderbare vorprogrammierte Protokoll eine wiederholbare Abfolge von Verarbeitungsschritten für die Bildung von Schichten einer IC auf einem flexiblen gemeinsamen Träger beinhaltet, und/oder ferner optional wobei das mindestens eine Verarbeitungsprotokoll mindestens ein dynamisches Protokoll umfasst.

5. System nach einem der vorherigen Ansprüche, wobei die Transfereinrichtung eine oder mehrere Trägerbewegungsvorrichtungen umfasst, optional wobei die eine oder mehreren Trägerbewegungsvorrichtungen eine Vielzahl von Roboterarmen umfassen, die betrieben werden können, um mindestens einen flexiblen gemeinsamen Träger auf dem jeweiligen starren Träger innerhalb eines Moduls von einem Modul zu einem anderen Modul zu bewegen, zu oder von einer Station und/oder zu und/oder von einer Pufferstation zu bewegen, ferner optional wobei die Vielzahl von Roboterarmen jeweils betrieben werden kann, um eine Chargenladevorrichtung zu bewegen, die konfiguriert ist, um einen oder mehrere flexible gemeinsame Träger auf den jeweiligen starren Trägern aufzunehmen, oder wobei die Vielzahl von Roboterarmen jeweils betrieben werden kann, um einen oder mehrere flexible gemeinsame Träger direkt auf den jeweiligen starren Trägern zu bewegen.

6. System nach einem der vorherigen Ansprüche, wobei jedes Verarbeitungsmodul ein oder mehrere Teilmodule umfasst.

7. System nach Anspruch 6, wobei jedes Teilmodul innerhalb eines Verarbeitungsmoduls betrieben werden kann, um einen der Verarbeitungsschritte bei der Herstellung einer IC auszuführen.

8. System nach Anspruch 6 oder Anspruch 7, wobei ein Teilmodul betrieben werden kann, um mindestens eine Schicht einer IC auf einem flexiblen gemeinsamen Träger zu bilden.

9. System nach einem der vorherigen Ansprüche, umfassend eine oder mehrere Masken für jede einer Vielzahl von IC-Konstruktionen.

10. Verfahren zum Herstellen einer Vielzahl von integrierten Schaltungen, ICs, die auf einem gemeinsamen Träger montiert sind, das Verfahren umfassend:
Bereitstellen mindestens eines flexiblen gemeinsamen Trägers (3), wobei jeder flexible gemeinsame Träger auf einem entsprechenden starren Träger (5) ist;
Bereitstellen einer Eingangsstation (11), in die der mindestens eine flexible gemeinsame Träger auf den jeweiligen starren Trägern geladen wird,
Bereitstellen einer Ausgangsstation (29), in die der mindestens eine flexible gemeinsame Träger auf den jeweiligen starren Trägern aufgenommen wird, nachdem eine Vielzahl von ICs auf dem mindestens einen flexiblen gemeinsamen Träger montiert worden ist;
Bereitstellen einer Vielzahl von Verarbeitungsmodulen (17, 19, 21), wobei jedes Verarbeitungsmodul betrieben werden kann, um mindestens einen der Schritte zum Bildung einer IC auf dem mindestens einen flexiblen gemeinsamen Träger und auf den jeweiligen starren Trägern auszuführen,
Bereitstellen einer Transfereinrichtung (13), die betrieben werden kann, um den mindestens einen flexiblen gemeinsamen Träger auf den jeweiligen starren Trägern von der Eingangsstation zu der Ausgangsstation und zu einem oder mehreren der Verarbeitungsmodule zu transferieren;
Steuern jedes mindestens einen flexiblen gemeinsamen Trägers auf den jeweiligen starren Trägern durch eines oder mehrere der Vielzahl von Verarbeitungsmodulen gemäß einem Verarbeitungsprotokoll, umfassend eine Vielzahl von veränderbaren vorprogrammierten Protokollen, von der Eingangsstation zu der Ausgangsstation,
Steuern der Verarbeitungsschritte von jedem Prozessmodul; und
Steuern der Bewegung von jedem flexiblen gemeinsamen Träger auf dem jeweiligen starren träger von der Eingangsstation zu der Ausgangsstation und zu einem oder mehreren Verarbeitungsmodulen unabhängig von einem anderen flexiblen gemeinsamen Träger auf dem jeweiligen starren Träger,
wobei jeder flexible gemeinsame Träger während des gesamten Verfahrens auf dem jeweiligen starren Träger gehalten wird.

11. Verfahren nach Anspruch 10, umfassend ein Auswählen eines veränderbaren programmierten Protokolls aus der Vielzahl von veränderbaren vorprogrammierten Protokollen für das mindestens eine Verarbeitungsprotokoll, und optional Auswählen einer oder mehrerer Masken für eine IC-Konstruktion umfasst.

12. Zentrales Transfersystem (200) für ein System zum Herstellen einer Vielzahl von integrierten Schaltungen (ICs), umfassend:
eine Anordnung einer mittleren Säule (213), die eine Längsachse aufweist;
mindestens ein Speicherelement, das funktionsfähig an der Längsachse der mittleren Säulenanordnung und koaxial dazu montiert ist, umfassend mindestens eine Aufnahme, die konfiguriert ist, um mindestens einen flexiblen gemeinsamen Träger (3) aufzunehmen und zu speichern, wobei jeder flexible gemeinsame Träger auf einem jeweiligen starren Träger (5) ist; und
wobei die mittlere Säulenanordnung konfiguriert ist, um ein beliebiges des mindestens einen Speicherelements drehbar um und/oder linear entlang der Längsachse zu bewegen, um einen beliebigen des mindestens einen Behälters an einem vorbestimmten Verarbeitungsmodul (211, 217, 219, 221) des Systems zum Herstellen einer Vielzahl von ICs bereitzustellen, und wobei die mittlere Säulenanordnung ferner einen internen Handhabungsmechanismus umfasst, der konfiguriert ist, um den mindestens einen gemeinsamen Träger auf dem jeweiligen starren Träger entlang der Längsachse aufzunehmen und zu einem von beliebigen der Vielzahl von mindestens einem Speicherelement zu bewegen.

13. Zentrales Transfersystem nach Anspruch 12, wobei die mittlere Säulenanordnung einen Drehtischmechanismus umfasst, der angepasst ist, um eines der mindestens einen Speicherelemente drehbar um die Längsachse zu bewegen, wobei der Drehtischmechanismus optional auch angepasst ist, um die mittlere Säulenanordnung entlang der Längsachse zu bewegen.

14. Zentrales Transfersystem nach Anspruch 12 oder Anspruch 13, umfassend eine Vielzahl des mindestens einen Speicherelements, das entlang der Längsachse funktionsfähig gestapelt ist, optional wobei jedes der Vielzahl von mindestens einem Speicherelement unabhängig von einem benachbarten der Vielzahl von mindestens einem Speicherelement um die Längsachse drehbar ist.

## Revendications

1. Système (1) destiné à la fabrication d'une pluralité de circuits intégrés, CI, montés sur un support commun souple, le système comprenant :
une station d'entrée (11) conçue pour recevoir au moins un support commun souple (3), chaque support commun souple étant sur un élément porteur rigide respectif (5) ;
une station de sortie (29) conçue pour recevoir le au moins un support commun souple sur les éléments porteurs rigides respectifs après qu'une pluralité de CI sont formés sur le au moins un support commun souple ;
une pluralité de modules de traitement (17, 19, 21), chaque module de traitement servant à effectuer au moins une étape de traitement en vue de la formation des CI sur le au moins un support commun souple tandis qu'ils sont sur les éléments porteurs rigides respectifs ;
un moyen de transfert (13) servant à transférer le au moins un support commun souple sur les éléments porteurs rigides respectifs de la station d'entrée à la station de sortie et à un ou plusieurs des modules de traitement entre celles-ci ;
un moyen de commande (7) servant à guider le au moins un support commun souple sur les éléments porteurs rigides respectifs à partir de la station d'entrée jusqu'à la station de sortie à travers un ou plusieurs de la pluralité de modules de traitement selon au moins un protocole de traitement comprenant une pluralité de protocoles préprogrammés modifiables ;
le moyen de commande servant à guider le mouvement d'un support commun souple sur l'élément porteur rigide respectif à partir de la station d'entrée jusqu'à la station de sortie et à travers un ou plusieurs des modules de traitement indépendamment de tout autre support commun souple sur l'élément porteur rigide respectif,
chaque support commun souple étant maintenu sur l'élément porteur rigide respectif dans tout le système.

2. Système selon la revendication 1, ledit moyen de commande comprenant un dispositif de commande de système et une pluralité de dispositifs de commande de système secondaire servant à guider respectivement le système et chacun de la station d'entrée, de la station de sortie, d'une station tampon et des modules de traitement.

3. Système selon la revendication 1, ledit moyen de commande servant à sélectionner l'un de la pluralité de protocoles préprogrammés modifiables pour le au moins un protocole de traitement.

4. Système selon une quelconque revendication précédente, ledit protocole préprogrammé modifiable comprenant un guidage séquentiel du, ou de chaque, support commun souple sur l'élément porteur rigide respectif vers au moins un module de dépôt, un module de structuration et un module de gravure, et/ou éventuellement ledit protocole préprogrammé modifiable comprenant une séquence reproductible d'étapes de traitement pour la formation de couches d'un CI sur un support commun souple, et/ou en outre éventuellement ledit au moins un protocole de traitement comprenant au moins un protocole dynamique.

5. Système selon l'une quelconque des revendications précédentes, ledit moyen de transfert comprenant un ou plusieurs dispositifs de déplacement de support, éventuellement ledit ou lesdits dispositifs de déplacement de support comprenant une pluralité de bras robotiques servant à déplacer au moins un support commun souple sur l'élément porteur rigide respectif à l'intérieur d'un module, à partir d'un module jusqu'à un autre module, jusqu'à une station ou à partir de celle-ci et/ou jusqu'à une station tampon et/ou à partir de celle-ci, en outre éventuellement ladite pluralité de bras robotiques servant chacun à déplacer un dispositif de chargement de lots conçu pour recevoir un ou plusieurs supports communs souples sur les éléments porteurs rigides respectifs, ou ladite pluralité de bras robotiques servant chacun à déplacer directement un ou plusieurs supports communs souples sur les éléments porteurs rigides respectifs.

6. Système selon l'une quelconque des revendications précédentes, chaque module de traitement comprenant un ou plusieurs sous-modules.

7. Système selon la revendication 6, chaque sous-module à l'intérieur d'un module de traitement servant à effectuer l'une des étapes de traitement dans la formation d'un CI.

8. Système selon la revendication 6 ou la revendication 7, un sous-module servant à former au moins une couche d'un CI sur un support commun souple.

9. Système selon l'une quelconque des revendications précédentes, comprenant un ou plusieurs masques pour chacune d'une pluralité de conceptions de CI.

10. Procédé de fabrication d'une pluralité de circuits intégrés, CI, montés sur un support commun, le procédé comprenant :
la fourniture d'au moins un support commun souple (3), chaque support commun souple étant sur un élément porteur rigide respectif (5) ;
la fourniture d'une station d'entrée (11) dans laquelle le au moins un support commun souple sur les éléments porteurs rigides respectifs est chargé ;
la fourniture d'une station de sortie (29) dans laquelle le au moins un support commun souple sur les éléments porteurs rigides respectifs est reçu après qu'une pluralité de CI sont montés sur le au moins un support commun souple ;
la fourniture d'une pluralité de modules de traitement (17, 19, 21), chaque module de traitement servant à effectuer au moins l'une des étapes de formation d'un CI sur le au moins un support commun souple tout en étant sur les éléments porteurs rigides respectifs ;
la fourniture d'un moyen de transfert (13) servant à transférer le au moins un support commun souple sur les éléments porteurs rigides respectifs de la station d'entrée à la station de sortie et à un ou plusieurs des modules de traitement ;
le guidage de chacun du au moins un support commun souple sur les éléments porteurs rigides respectifs à partir de la station d'entrée jusqu'à la station de sortie à travers un ou plusieurs de la pluralité de modules de traitement selon un protocole de traitement comprenant une pluralité de protocoles préprogrammés modifiables ;
le guidage des étapes de traitement de chaque module de processus ; et
le guidage du mouvement de chaque support commun souple sur l'élément porteur rigide respectif à partir de la station d'entrée jusqu'à la station de sortie et jusqu'à l'un ou plusieurs des modules de traitement indépendamment de tout autre support commun souple sur l'élément porteur rigide respectif,
chaque support commun souple est maintenu sur l'élément porteur rigide respectif tout au long du procédé.

11. Procédé selon la revendication 10, comprenant la sélection d'un protocole préprogrammé modifiable parmi la pluralité de protocoles préprogrammés modifiables pour le au moins un protocole de traitement, et éventuellement comprenant la sélection d'un ou plusieurs masques pour une conception de CI.

12. Système de transfert central (200) pour un système destiné à la fabrication d'une pluralité de circuits intégrés (CI), comprenant :
un ensemble colonne centrale (213) comportant un axe longitudinal ;
au moins un élément de stockage, monté fonctionnellement sur ledit axe longitudinal dudit ensemble colonne centrale et coaxialement avec celui-ci, comprenant au moins un réceptacle conçu pour recevoir et stocker au moins un support commun souple (3), chaque support commun souple étant sur un élément porteur rigide respectif (5) ; et
ledit ensemble colonne centrale étant conçu pour déplacer l'un quelconque desdits au moins un élément de stockage de manière rotative autour et/ou linéairement le long dudit axe longitudinal, de façon à fournir l'un quelconque desdits au moins un réceptacle à un module de traitement prédéfini (211, 217, 219, 221) du système en vue de la fabrication d'une pluralité de CI, et ledit ensemble colonne centrale comprenant en outre un mécanisme de manipulation interne conçu pour recevoir et déplacer ledit au moins un support commun sur l'élément porteur rigide respectif le long dudit axe longitudinal jusqu'à l'un quelconque de ladite pluralité d'au moins un élément de stockage et à partir de celui-ci.

13. Système de transfert central selon la revendication 12, ledit ensemble colonne centrale comprenant un mécanisme de table tournante adapté pour déplacer l'un quelconque dudit au moins un élément de stockage de manière rotative autour dudit axe longitudinal, éventuellement ledit mécanisme de table tournante étant en outre adapté pour déplacer ledit ensemble de colonne centrale le long dudit axe longitudinal.

14. Système de transfert central selon la revendication 12 ou la revendication 13, comprenant une pluralité dudit au moins un élément de stockage empilés de manière fonctionnelle le long dudit axe longitudinal, éventuellement l'un quelconque de ladite pluralité d'au moins un élément de stockage pouvant tourner autour dudit axe longitudinal indépendamment de l'un quelconque adjacent de ladite pluralité d'au moins un élément de stockage.
